# EUROPEAN PATENT SPECIFICATION

(11) **EP 0 384 488 B1**
(45) Date of publication and mention of the grant of the patent: **21.08.1996**
(21) Application number: 90103598.0
(22) Date of filing: 23.02.1990
(51) Int. Cl.: H01L 23/40, H05K 7/12

(54) **Mounting device for transistors or other warming components**
Montage-Vorrichtung für Transistoren und andere sich erwärmende Bauteile
Dispositif de montage pour transistors et autres composants qui se chauffent

(30) Priority: 24.02.1989 FI 890895
(43) Date of publication of application: 29.08.1990
(73) Proprietor: NOKIA MOBILE PHONES LTD., SF-24100 Salo (FI)
(72) Inventor: Sakari, Antti, SF-33100 Tampere (FI)
(74) Representative: Frain, Timothy John

(56) References cited:
- EP-A- 0 052 025
- EP-A- 0 235 657
- EP-A- 2 445 983
- US-A- 4 288 839

## Description

This invention relates to a device for mounting transistors or other warming components removably in a casing or other construction and for pressing them tightly against the wall of the casing or other construction.

Generally warming components, e.g. power transistors, are fixed to the wall of a casing containing the printed board by screwing, soldering or clamps or clips of different types. Since on the one hand, the transistors are small, and on the other hand, the casings in which the transistors are fixed are small, the fixing of transistors by screws, soldering or clamps is a difficult and time-consuming operation due to the limited space. Soldering also has the disadvantage of making it difficult to remove the transistor for instance in order to exchange it.

High-power power transistors warm up during use and in order to withdraw the heat, the transistors are attached to the wall of a casing containing the printed board with the intermediation of a cooling board. However, when using these methods of attachment, the contact between the cooling board and the casing wall is not very good. A known device for making contacts between components is disclosed in German patent application DT 24 45 983 which describes a device for simultaneously pressing a plurality of contacts against corresponding contacts under spring pressure.

The purpose of the invention is to provide a device, by means of which transistors or other warming components can be simply mounted removably in a casing and simultaneously pressed against the casing wall in order to achieve a good contact, so that the heat will be well conducted from the transistors into the wall. The device is particularly suitable for components packed in a TO-220 casing.

These purposes have been most satisfactorily achieved with the device of the invention, the characteristics of which appear from the enclosed claims.

The present invention provides an assembly for removably mounting transistors and power devices, comprising: a transistor or a power device; a casing having walls for housing the transistor or power device; and a frame portion in which at least one hole is provided, a spring member disposed in the hole and a push-button disposed in the hole and on which the spring member acts and by means of which the transistor or power device is able to be pressed against a wall of the casing characterised in that the push-button comprises a guide pin and in that the frame portion has a guide groove extending through the wall surrounding the hole and adapted to co-operate with the guide pin for moving the push-button between a readiness position in which the push-button is held away from the transistor or power device and an operating position in which the push-button tightly presses the transistor or power device against the wall of the casing.

The invention is described below with reference to the enclosed drawings, in which
figure 1 shows a top view of a preferred device of the invention,
figure 2 shows a lateral view of the construction of figure 1,
figure 3 shows a cross-section of figure 1 along the line A-A,
figure 4 shows a top view of the device of the invention disposed in using position,
figure 5 shows a cross-section along the line B-B of figure 4.

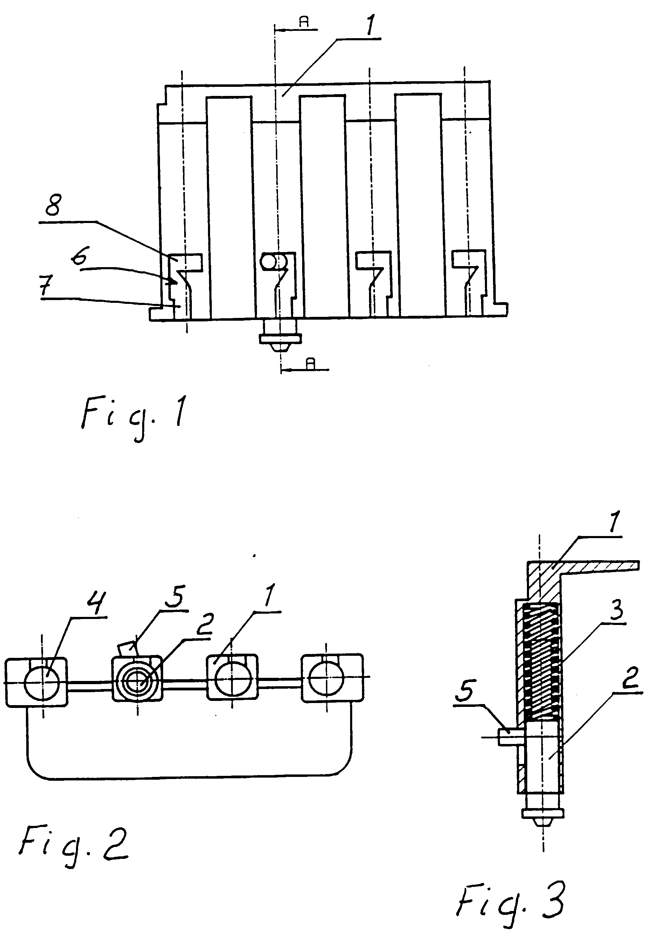

In figures 1-3, the frame portion of the device of the invention is indicated with the reference 1. In the frame portion 1 four holes 4 are provided. In order to simplify the drawing, only the parts disposed in one hole have been made visible. In the hole 4, a spring 3 is disposed, extending all the way to the bottom. On top of the spring 3, a cylindrical push-button 2 is disposed in the hole 4. The push-button 2 has a guide pin 5 emerging from its cylindrical surface. The frame portion 1 correspondingly comprises a guide groove 6 for the guide pin 5. The guide groove 6 has a first groove portion 7 in the direction of the hole, and as an extension of this, a second groove portion 8, which is perpendicular to the first groove portion 7. As the guide pin 5 is in the first groove portion 7 the push-button 2 is in operating position i.e. the spring acts on it, pressing the push-button 2 against the cooling board of the transistor (cf. figure 5). The guide pin 5 being in the second groove portion 8, i.e. the position of figure 1, the push-button 2 is locked into a readiness position.

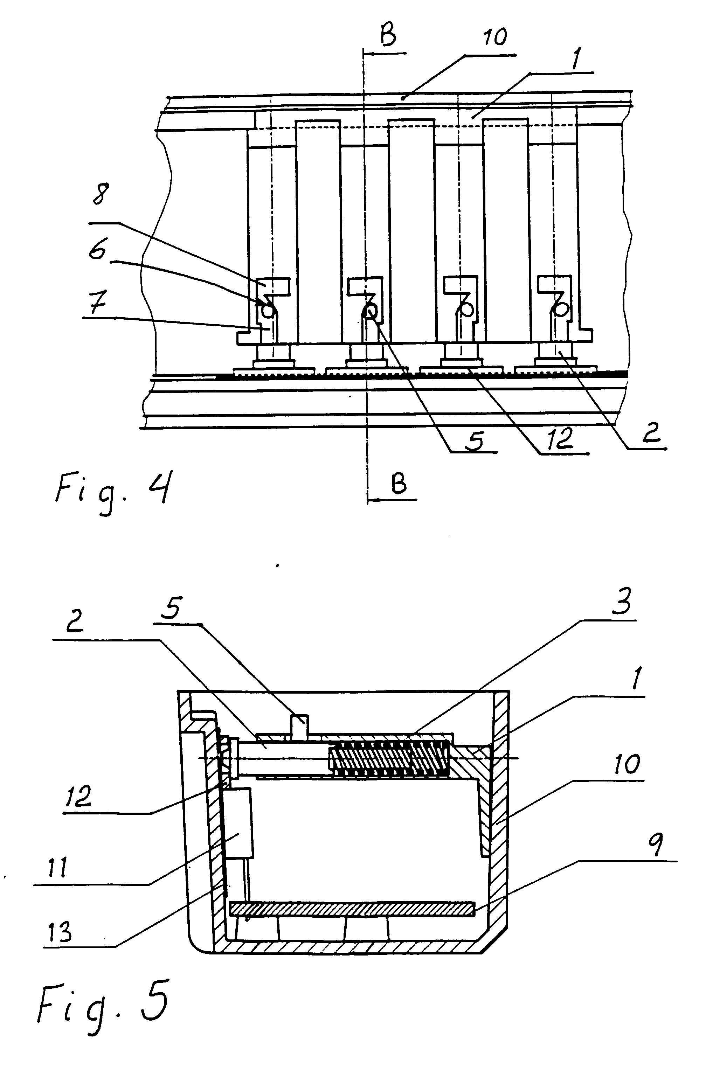

Figures 4 and 5 show the device of the invention disposed in using position i.e. in the casing 10 containing the printed board 9. The transistor, which is in a TO-220 casing, is indicated with the reference 11 in figure 5 and this casing also comprises a flange portion 12 for cooling and fixing purposes. Between the transistor casing 11 and the casing 10 a heat conducting insulation layer 13 is disposed. The push-button 2 being in its operating position, i. e. the guide pin 5 in the first groove portion 7, the spring acts on the push-button 2 pressing it against the cooling board 12 of the transistor, whereby the cooling board is pressed by the spring effect against the wall of the casing 10. Thus an excellent contact between the cooling board 12 and the casing 10 is achieved, the heat being thus conducted from the transistor to the wall.

In a preferred embodiment, the other end of the push-button 2 has a smaller diameter than the end pressing the component 11, thus forming an arm, placed inside the helical spring 3. The device can be made of plastic material, although other materials are also possible.

Referring to figures 4 and 5, the transistor 11 is mounted by using the device of the invention so that the push-button 2 is brought into back position, i.e. the guide pin 5 is in the groove portion 8, the transistor 11 is brought into the casing 10 and pressed against the wall of the casing, the push-button 2 is turned clockwise by means of the guide pin 5, the push-button 2 passes by the narrowing between the groove portions 8 and 7, after which the spring 3 presses the push-button 2 against the cooling board 12 of the transistor, pressing the transistor tightly against the wall of the casing 10. Before mounting the transistor, the mounting device is disposed in the casing on some suitable support and so that the flange portion at one end of the device is supported by some support, thus acting as a counter-support of the springs 2. The attachment of the device and the transistors is carried out without using fixing members, such like screws. The device can of course be fixed to the casing by means of various fixing members.

Only the use of the device of the invention for mounting transistors in a casing and pressing against the casing wall has been described above, however, the device can of course be applied to other warming components.

## Claims

1. An assembly for removably mounting transistors (11,12) and power devices, comprising:
a transistor (11,12) or a power device;
a casing (10) having walls for housing the transistor (11,12) or power device; and
a frame portion (1) in which at least one hole (4) is provided, a spring member (3) disposed in the hole and a push-button (2) disposed in the hole and on which the spring member (3) acts and by means of which the transistor (11,12) or power device is able to be pressed against a wall of the casing (10) **characterised** in that the push-button (2) comprises a guide pin (5) and in that the frame portion (1) has a guide groove (6) extending through the wall surrounding the hole and adapted to co-operate with the guide pin (5) for moving the push button (2) between a readiness position in which the push button (2) is held away from the transistor (11,12) or power device and an operating position in which the push-button (2) tightly presses the transistor (11,12) or power device against the wall of the casing (1).

2. An assembly according to claim 1, **characterised** in that the guide groove (6) comprises a first groove portion (7) in a direction transverse to the wall and coming from the mouth of the hole and a second groove portion (8) perpendicular to the first groove portion, into which the guide pin (5) can be inserted in order to lock the push-button (2) in the readiness position, the guide pin (5) being movable from the second groove portion (8) into the first groove portion (7) in order to bring the push-button into the operating position.

3. An assembly according to any of the preceding claims, **characterised** in that the hole (4) and the push-button (2) are of cylindrical cross-section.

4. An assembly according to any of the preceding claims, **characterised** in that the frame portion (1) comprises a plurality of holes (4) respectively including a spring member (3) and a push button (2) inserted therein.

## Patentansprüche

1. Einrichtung zur lösbaren Montage von Transistoren (11, 12) und Leistungselementen, mit:
- einem Transistor (11, 12) oder einem Leistungselement:
- einem Gehäuse (10) mit Wänden zur Unterbringung des Transistors (11, 12) oder des Leistungselements; und
- einem Rahmenteil (1) mit wenigstens einem Loch (4), einem im Loch vorhandenen Federelement (3) sowie einem im Loch vorhandenen Druckknopf (2), auf den das Federelement (3) wirkt, und durch den der Transistor (11, 12) oder das Leistungselement gegen die Wand des Gehäuses (10) gepreßt werden, **dadurch gekennzeichnet**, daß der Druckknopf (2) einen Führungsstift (5) aufweist, während der Rahmenteil (1) einen Führungsschlitz (6) enthält, der sich durch die das Loch umgebende Wand erstreckt und mit dem Führungsstift (5) zur Bewegung des Druckknopfes (2) zwischen einer Betriebsbereitschaftsposition, in der der Druckknopf (2) vom Transistor (11, 12) oder dem Leistungselement entfernt gehalten wird, und einer Betriebsposition kooperiert, in der der Druckknopf (2) den Transistor (11, 12) oder das Leistungselement fest gegen die Wand des Gehäuses (10) drückt.

2. Einrichtung nach Anspruch 1, **dadurch gekennzeichnet**, daß der Führungsschlitz (6) einen ersten Schlitzteil (7) in Transversalrichtung der Wand und von der Mündung des Loches kommend, sowie einen senkrecht zum ersten Schlitzteil liegenden zweiten Schlitzteil (8) aufweist, in den der Führungsstift (5) eingesetzt ist, um den Druckknopf (2) in der Betriebsbereitschaftsposition zu verriegeln, wobei der Führungsstift (5) aus dem zweiten Schlitzteil (8) in den ersten Schlitzteil (7) verschiebbar ist, um den Druckknopf in seine Betriebsposition zu überführen.

3. Einrichtung nach einem der vorhergehenden Ansprüche, **dadurch gekennzeichnet**, daß das Loch (4) und der Druckknopf (2) im Querschnitt zylindrisch ausgebildet sind.

4. Einrichtung nach einem der vorhergehenden Ansprüche, **dadurch gekennzeichnet**, daß der Rahmenteil (1) eine Mehrzahl von Löchern (4) aufweist, in denen sich jeweils ein Federelement (3) und ein Druckknopf (2) befinden.

## Revendications

1. Assemblage pour monter de façon amovible des transistors (11, 12) et des composants de puissance, comprenant :
un transistor (11, 12) ou un composant de puissance ;
un boîtier (10) possédant des parois pour loger le transistor (11, 12) ou le composant de puissance ; et
une partie de cadre (1) dans laquelle au moins un trou (4) est ménagé, un ressort (3) est placé dans le trou et un bouton poussoir (2) est disposé dans le trou et sur lequel le ressort (3) agit et au moyen duquel le transistor (11, 12) ou le composant de puissance peut être pressé contre la paroi du boîtier (10),
**caractérisé** en ce que le bouton poussoir (2) comprend une broche de guidage (5) et en ce que la partie de cadre (1) comporte une rainure de guidage (6) s'étendant à travers la paroi entourant le trou et adaptée pour fonctionner simultanément avec la broche de guidage (5) pour faire manoeuvrer le bouton poussoir (2) entre une position d'attente dans laquelle le bouton poussoir (2) est maintenu à distance du transistor (11, 12) ou du composant de puissance, et une position active dans laquelle le bouton poussoir (2) presse fermement le transistor (11, 12) ou le composant de puissance contre la paroi du boîtier (1).

2. Assemblage selon la revendication 1, **caractérisé** en ce que la rainure de guidage (6) comporte une première portion de rainure (7) selon la direction transverse à la paroi et provenant de l'entrée du trou et une seconde portion de rainure (8), perpendiculaire à la première portion de rainure, dans laquelle la broche de guidage (5) peut être insérée afin de verrouiller le bouton poussoir (2) dans la position d'attente, la broche de guidage (5) pouvant être déplacée de la seconde portion de rainure (8) dans la première portion de rainure (7) afin d'amener le bouton poussoir (2) dans la position active de fonctionnement.

3. Assemblage selon l'une quelconque des revendications précédentes, **caractérisé** en ce que le trou (4) et le bouton poussoir (2) sont de section cylindrique.

4. Assemblage selon l'une quelconque des revendications précédentes, **caractérisé** en ce que la partie de cadre (1) comporte une pluralité de trous (4) comprenant respectivement un ressort (3) et un bouton poussoir (2) insérés à l'intérieur.
